# EUROPEAN PATENT APPLICATION

(11) **EP 3 346 209 A1**
(43) Date of publication of application: **11.07.2018**
(21) Application number: 16840871.4
(22) Date of filing: 09.08.2016
(51) Int. Cl.: F25B 21/02, H05K 7/14, H05K 7/20

(54) **COMPUTER WITH SPECIAL OUTER CASING ALLOWING THE SITUATION THEREOF IN EXPLOSIVE ATMOSPHERES**

(30) Priority: 31.08.2015 ES 201531240
(71) Applicant: LFK Global Technology Services, S.L., 41720 Los Palacios Y Vfca. (Sevilla) (ES)
(72) Inventor: LEO GARCIA, Juan, 41720 Los Palacios Y Vfca. (sevilla) (ES)
(74) Representative: Bartrina Diaz, José María
(86) International application number: PCT/ES2016/070598
(87) International publication number: WO 2017/037315

(57) **Abstract**

Computer with special outer casing allowing the situation thereof in explosive atmospheres through the creation of an airtight interior volume, where the computer is housed; featuring a Peltier cell, such that the system as a whole is suitable for use in an explosive atmosphere without affecting the performance of the computer, since it is able to maintain an adequate temperature for electronic elements.

## Description

### OBJECT OF THE INVENTION

This invention is of a physical computer device (hardware comprising at least the tower and monitor), which is enclosed in an airtight container that allows for heat exchange as well as refrigeration, despite its airtightness, so that it can be installed in ATEX spaces (explosive atmospheres with different levels of danger). The full set is made up of a single chassis.

There are industrial spaces where the use of computers is essential for conducting regular activities, and which are classed as ATEX (explosive atmosphere) spaces. For example, vehicle paint and sheet metal repair workshops, where paints are mixed using a computer-controlled system, and the existence of paint solvents means that the work area is classed as an ATEX space. In many cases, these industrial areas have computer systems that are not suitable for this type of environment, which creates a high risk of explosion, due to the presence of a heat source and components that are not suitably protected from the environment. In other cases, the computer is placed inside another case, which, though it does protect against explosions, also eliminates the possibility of cooling the computer, which leads to errors in the data processing system, which render this solution impractical.

Modern computers need to be kept under a certain maximum operating temperature. Otherwise, there will be failures in the computer system when the temperatures in certain electrical circuits that make up the computer reach a certain value. To minimise these failures, the computer systems have heat exchange systems between the inside of the computer and the outside. In all known cases, the exchange system uses rotating blades which reduce the inside temperature to some degree, depending on the outside temperature, through forced ventilation.

### BACKGROUND TO THE INVENTION

There are currently different systems that perform analogous processes. At an industrial level, there are many manufacturers of electrical components certified for use in ATEX spaces, which use screens with built-in screens. This is the case, for example, of the company ABSA (outdoor computers), which sells computers with integrated screens with ATEX and UL classification for hazardous environments. The computers work under extreme temperature conditions and the display can be read in broad daylight, and they can control machines or processes, display information and collect production information. Another example is the company ROCKWELL AUTOMATION (computers with screens designed for hazardous environments), which wells computers with screens classed as suitable for ATEX Category 3 - gas and dust - for hazardous areas, and designed for difficult environments.

In all known cases, solutions are provided that keep the internal circuitry directly independent from the environment outside.

However, the state of the art does not have any devices that include an intermediate airtight chamber as an insulation method for ATEX spaces. There are also no inventions that feature air exchange systems for internal refrigeration, maintaining an optimum internal temperature for the operation of the machine, regardless of the temperature of the working environment.

The proposed invention has the following advantages, and therefore novelties, compared to the known state of the art, insofar as there is no equivalent system that features all the characteristics of this solution:
- The designed device creates an airtight space, which in itself makes the system suitable for ATEX spaces. The computer system is placed in the device, meaning it is confined in a control environment.
- The designed device regulates the inside temperature with a system that does not require any heat exchange with the outside. This makes it possible to lower the temperature such that it is cooler than the outside, which ensures the computer works correctly even in extreme ambient temperatures.

### EXPLANATION OF THE INVENTION

To explain the invention, and to achieve the objectives and avoid the issues mentioned in the previous section, the invention consists of a specific computer system for use in ATEX (high risk of explosion) areas.

The invention comprises the following elements:
a. Conventional computer, most commonly industrial computers.
b. Outer case that creates an airtight space.
c. Temperature exchange cells without ventilation, known as Peltier.

More specifically, the invention has an outer case, constructed in such a way that the inside is airtight. It works using seals on the access doors, cable bushings and suitable plugs at the connection points of the computer's peripherals. The airtight box will house two different systems, arranged in such a way that their work is optimised. On the one hand, a temperature capturing system that is already in the market will be installed. The system uses what are known at Peltier cells, which makes it possible to reduce the temperature inside, concentrating the temperature in such a way that it can be transferred to the outside.

Inside the airtight box is a computer, the components of which are arranged in such a way that heat change is possible. The heat is exchanged with the outside, directing the flow to where collection by the Peltier cell is maximised.

The correct arrangement of these three components makes it possible to have a hardware system that complies with systems that can work in ATEX, which is the purpose of this invention.

### DESCRIPTION OF THE DRAWINGS

To complement the description, and to aid the understanding of the characteristics of the invention, according to an example of a preferred embodiment of the invention, a set of figures is attached to this description. These figures are descriptive only and do not limit the invention. The figures are the following:

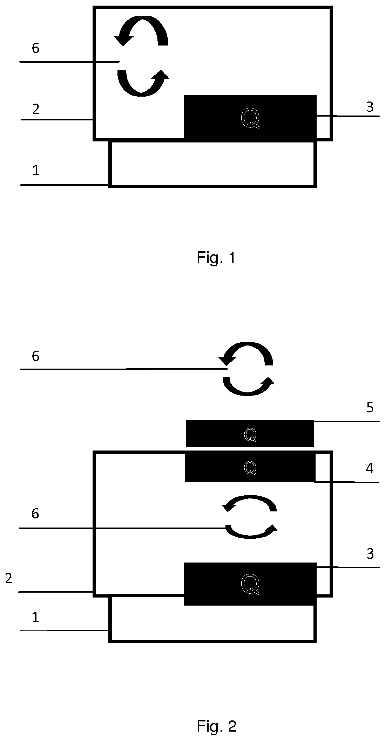

Figure 1: Diagram showing the heat exchange system in the state of the art.
Figure 1: Diagram showing the heat exchanger proposed in the proposed device.

The following constituent elements can be highlighted in the aforementioned figures:
01. Computer.
02. Outer case.
03. Conventional heat exchange system for computers.
04. Peltier cell.
05. Grille based heat exchanger.
06. Flow of heat.

### PREFERRED EMBODIMENT EXAMPLE

As an example of a preferred embodiment of this invention, "Computer with special outer casing allowing the situation thereof in explosive atmospheres", it comprises the following components:
1. Computer(1) which, in turn, will have its own conventional computer heat exchange system(3). The computer system will have its own user interface screen, for which the conventional computer heat exchange system(3) should be enough to regulate the temperature of the screen.
2. Outer case(2), which is airtight once the access points are closed. All access points, which are necessary to assemble and maintain the equipment will have joints or a similar system to ensure the airtightness of the interior. This is a requirement for all elements classed as suitable for ATEX spaces. The orifices through which the cables pass through should have ATEX certified bushings, with an IP rating of at least 65 (the first digit, 6, refers to dust insulation and the second digit, 5, indicates that no water stream should be able to enter (from any angle). This way the airtightness of the interior can be guaranteed. The outside will have a radiator-based heat exchange system(5), designed to evacuate heat through a heat exchanger(6).
   The outer case(2) should have data connections for communicating with the computer(1), which will be housed on the inside. The ports should themselves be suitable for the environment and working conditions of the system as a whole.
3. For internal refrigeration, the device will have a system that does not feature any air exchanger. The temperature will be self-regulated to preserve optimum conditions inside, regardless of the temperature of the working space. Thus, the inside of the outer cover(2) shall have a system based on a Peltier cell(4) that makes it possible to reduce the temperature. This means that there can be a heat flow(6) inside the outer cover.
4. In terms of peripherals, the proposed device can be completed with a foldable support for mouse and keyboard, as well as an adjustable support structure allowing for the entire system to be attached to a standard work bench.

## Claims

1. Computer with special outer casing allowing the situation thereof in explosive atmospheres, **characterised by** comprising the following elements:
a) Computer with its own conventional computer heat exchange system. The computer will have its own user interface screen.
b) Outer case, which is airtight once the access points are closed. All access points, which are necessary to assemble and maintain the equipment will have joints or a similar system to ensure the airtightness of the interior. The orifices for the cables will have ATEX approved bushings and at least IP 65 airtightness certification. The outside will also feature an aluminium dissipater heat exchange system to lower the temperature through a heat exchange.
The outer cover features data connection points to communicate with the computer system, which will be inside.
c) Peltier cell system inside the outer cover.
d) In terms of peripherals, the proposed device can be completed with a foldable support for mouse and keyboard, as well as an adjustable support structure allowing for the entire system to be attached to a standard work bench.

2. Computer with special outer casing for use in explosive atmospheres according to claim 1, **characterised by** including a Peltier cell system inside the outer cover to reduce the temperature by creating a heat exchange inside the outer cover, able to maintain an optimum and self-regulated operating temperature on the inside.
